# EUROPÄISCHE PATENTANMELDUNG

(11) **EP 1 638 150 A2**
(43) Veröffentlichungstag der Anmeldung: **22.03.2006**
(21) Anmeldenummer: 05019592.4
(22) Anmeldetag: 08.09.2005
(51) Int. Cl.: H01L 31/042, H01L 31/18

(54) **Solarmodul**

(30) Priorität: 15.09.2004 DE 102004045050; 29.11.2004 DE 102004057663
(71) Anmelder: SUNWAYS AG Photovoltaics, 78467 Konstanz (DE)
(72) Erfinder: Nussbaumer, Hartmut, Dr., 78464 Konstanz (DE); Jooss, Wolfgang, Dr., 78462 Konstanz (DE); Weber, Lothar, Dipl.-Ing., 78467 Konstanz (DE); Boueke, Arnd, Dr., 78467 Konstanz (DE); Burkhardt, Roland, Dipl.-Ing., 8280 Kreuzlingen (CH)
(74) Vertreter: Pietruk, Claus Peter

(57) **Zusammenfassung**

Die Erfindung betrifft ein Solarmodul mit einem transparenten Träger und einer Mehrzahl voneinander beabstandeter, durch regulär angeordnete Löcher semitransparenter Solarzellen. Hierbei ist vorgesehen, dass der Träger an den Solarzellenzwischenräumen eine Ausbildung aufweist, die zusammen mit den regulären Solarzellenlöchern eine reguläre Opazität ergibt.

## Beschreibung

Die vorliegende Erfindung betrifft das oberbegrifflich Beanspruchte und befasst sich somit mit Solarmodulen.

Solarmodule sind bekannt. In Solarmodulen sind eine Vielzahl kleinerer Solarzellen auf einem Träger zu besser handhabbaren Einheiten zusammengefasst. Die einzelnen Solarzellen sind dabei deutlich kleiner als das Solarmodul selbst, was es erlaubt, die Solarzellen als kleine Einheiten preiswert herzustellen.

Es ist häufig gewünscht, Solarmodule in Fassaden und dergleichen anzuordnen, insbesondere dann, wenn diese gegen Süden hin ausgerichtet sind und nicht genügend geneigte Dachfläche zur Verfügung steht, um dort die gewünschte oder benötigte Energie zu erzeugen.

Problematisch ist nun, dass über Fassaden, insbesondere zum Süden hin ausgerichtete Fassaden, zeitweilig zwar ausreichend Licht in ein Gebäude gelassen werden soll, bei starker Sonneneinstrahlung aber eine Blendung im Inneren oder eine Innenraumüberhitzung zu vermeiden ist. Die typisch bei Südfassaden anwendbare Verschattung ist zudem dann nicht mehr möglich, wenn Solarmodule auf der Fassade angeordnet werden, da die Verschattung genau dann erfolgen müsste, wenn eine optimale hohe Produktion an Solarstrom möglich wäre und eine zwischen Solarmodulen und eigentlicher Gebäudewand verlaufende Verschattung architektonisch wenig elegant und konstruktiv aufwendig ist.

Die Aufgabe der vorliegenden Erfindung besteht darin, ein Solarmodul anzugeben, welches in einer breiteren Vielzahl von Fällen einsetzbar ist.

Die Lösung dieser Aufgabe wird in unabhängiger Form beansprucht. Bevorzugte Ausführungsformen finden sich in den Unteransprüchen.

Die vorliegende Erfindung schlägt somit in einem ersten Grundgedanken ein Solarmodul mit einem transparenten Träger und einer Mehrzahl voneinander beabstandeter, durch regulär angeordnete Löcher semitransparenter Solarzellen vor, bei welchem vorgesehen ist, dass der Träger an den Solarzellenzwischenräumen eine Ausbildung aufweist, die zusammen mit den regulären Solarzellenlöchern eine reguläre Opazität ergibt. Als Solarzellen kommen bevorzugt kristalline, insbesondere monokristalline, multikristalline, trikristalline oder EFG-Zellen in Frage.

Die vorliegende Erfindung beruht somit auf der konsequenten Umsetzung der Erkenntnis, dass eine Verschattung von Räumen entbehrlich wird, wenn hinreichend viel Licht am Eintritt in das Gebäudeinnere gehindert wird, während zugleich auf Grund der etwa näherungsweise logarithmischen Empfindlichkeit des Auges auch in Fällen geringer Außenhelligkeit durch geeignete reguläre Anordnung eine Vergleichmäßigung des Lichteinfalls erreicht werden kann, so dass ungeachtet einer eventuell nur geringen Durchlöcherung von Solarzellen und Trägern eine für den hinter der Anordnung befindlichen Betrachter ausreichende und ausreichend vergleichmäßigte Lichteinstrahlung erzielt wird.

Relevant ist hierbei, dass schon die Fortsetzung der Solarzellenlöcherregularität im Solarzellenlöcherzwischenraum zu einer signifikant verbesserten Innenraumausleuchtung führt, da der Innenraumbenutzer im Durchlicht keine Unterschiede zwischen Träger und Zelle zu erkennen vermag und auch weder größerflächige helle Bereiche die Dunkeladaption stören noch übermäßig große Bereiche einen zu geringen Lichteinfall bedingen.

Zur Erzielung der regulären Opazität sind unterschiedliche Vorgehensweisen möglich. So kann der Lochabstand auf den Zellen größer als die Solarzellenbeabstandung gewählt werden und der Trägerzwischenraum vollständig opak ausgelegt sein, so dass bei entsprechender Anordnung der Solarzellen die Übergänge nicht auffallen.

Während es weiter möglich ist, einen selbst diffus streuenden Träger zu verwenden, dessen Diffusivität den Solarzellenlöchern und der damit geschaffenen Solarzellentransparenz angepasst ist, ist es demnach bevorzugt und möglich, dass der Träger an den Lücken zwischen den Solarzellen, das heißt in jenem Bereich, um welchen sie beabstandet sind, allgemein opak oder nicht transparent ist und gleichfalls Löcher bzw. zumindest geringer opake Bereiche aufweist.

Auf diese Weise ergibt sich eine besonders hohe Vergleichmäßigung der Lichteinstrahlung und zugleich die gewünschte Durchlässigkeit.

Der Träger kann sowohl im sichtbaren als auch im infraroten Bereich transparent sein. Die Wahl der spektralen Durchlässigkeit kann dabei im Hinblick darauf getroffen werden, ob lediglich eine Beleuchtung des Bereichs hinter der Fassade, also zum Beispiel eines Innenraumes gewünscht ist oder ob statt dessen bzw. zusätzlich auch eine Erwärmung vorzusehen ist, etwa um im Winter die Aufheizung des hinter der Solarzellenmodulfassade gelegenen Bereiches zu gewährleisten.

Der Träger kann aus Glas oder Kunststoff, insbesondere wetterbeständigem Kunststoff wie PMMA oder dergleichen gebildet sein.

In einer bevorzugten Variante sind die Solarzellen gleichmäßig nebeneinander angeordnet, wobei sie etwa kachelartig gelegt sein können.

Die Löcher auf den Solarzellen selbst und/oder im Träger können äquidistant zueinander sein, was eine besonders gleichmäßige Lichteinstrahlung ermöglicht und/oder formfolgend, d.h. sie können eng nebeneinander angeordnet sein, um etwa der Linie eines Firmenlogos, Buchstabens usw. zu folgen.

Es ist in besonders bevorzugten Fällen möglich, nahe einiger der Löcher und/oder nahe allen der Löcher eine Hinterleuchtung vorzusehen, um etwa einem von außen auf die Fassade Blickenden ein Firmenlogo oder dergleichen zu präsentieren. Es ist dabei insbesondere möglich, Solarmodule in einer Fassade so zu kombinieren, dass in einigen der Solarmodulen eine Hinterleuchtung vorgesehen wird und in anderen eine Transparenz geschaffen wird. Dies kann dann vorteilhaft sein, wenn etwa ein mehrstöckiges Gebäude vorliegt, das mit einer einheitlichen Fassade versehen wird, wobei in den Geschossebenen dort, wo der Boden liegt, ohnehin keine Transparenz erforderlich ist.

In besonders bevorzugter Weise ist es möglich, ein Speichermittel für die Einspeicherung der mit den Solarzellen erzeugten Energie vorzusehen, das bei Bedarf die für die Hinterleuchtung benötigte Energie bereitstellt. Hinreichend helle Leuchtmittel für die Hinterleuchtung vorausgesetzt, kann dies bei Tage wie auch bei Nacht geschehen. Auf diese Weise lassen sich insbesondere auch neuartige Verkehrsschilder und dergleichen herstellen.

Bei den Solarzellen wird es sich typisch um kristalline, insbesondere multikristalline und/oder monokristalline und/oder trikristalline bzw. EFG-Solarzellen handeln.

Dass es im übrigen bei kristallinen Solarzellen schon Möglichkeiten gab, Löcher in diesen selbst vorzusehen, sei der Vollständigkeit halber erwähnt. Hingewiesen wird in diesem Zusammenhang etwa auf die US-PS 5,468,652, US-PS 6,384,317, US 5,704,992 und DE 44 26 347 A1, sowie auf verschiedene Veröffentlichungen von E. van Kerschaver et al., u. a. in Proceedings of the 2^{nd} World Conference on Photovoltaic Solar Energy Conversion, Wien, 1998, Seiten 1479, Proceedings of the 16^{th} EC PVSC, Glasgow 2000, S. 209 und Proceedings of the 17^{th} EC PVSC, München 2001.

Die Solarzellen werden in einem bevorzugten Fall als Rückkontaktsolarzellen ausgebildet. Dies erlaubt eine leichtere Montage bei zugleich architektonisch größeren Gestaltungsmöglichkeiten, wobei aber darauf hingewiesen sei, dass es nicht zwingend erforderlich ist, unbedingt Rückseitenkontakte zu verwenden.

Es sei darauf hingewiesen, dass es möglich ist, die Solarzellen mit einer Beschichtung, insbesondere einer reflektionsverringernden Beschichtung zu versehen, wobei diese Beschichtung die Farbe der Solarzellen verändern kann und im übrigen eine Anpassung der Solarzellenfarbe und einer Trägerbeschichtung zur Erzeugung der Opazität möglich ist.

Schutz wird weiter beansprucht für ein Verfahren zur Herstellung eines Solarmoduls aus einem Träger und einer Vielzahl von regulär angeordnete Löcher aufweisenden kristallinen Solarzellen, insbesondere wie vorstehend beschrieben, bei welchem vorgesehen ist, dass die Löcher durch Bohren, Laserschneiden, Ultraschallschneiden und/oder Stanzen in die Solarzellen eingebracht werden.

Die Art und Weise, wie Löcher in die Solarzellen eingebracht werden, ist also nicht dergestalt, dass nur besonders feine Löcher erzeugt werden müssen. Vielmehr sind Durchmesser von um ab 0,1 mm ausreichend, um die Effekte der vorliegenden Erfindung zu erzielen, obschon das Vorsehen kleinerer Durchmesser gleichzeitig möglich ist. Es lassen sich aber auch mit signifikant größeren Solarzellenlöchern noch reguläre bzw. für einen Betrachter insbesondere quasi homogene Strukturen erzielen. So sind Löcher von zum Beispiel 5 mm Durchmesser gut geeignet, um in Dachverglasungen für eine erforderliche Transparenz zu sorgen, ohne durch zu feine Lochungen die Herstellungskosten über Gebühr zu erhöhen. Die über eine größere Fläche verteilte gleichmäßige Lochung vermeidet Adaptionsprobleme des Auges auch bei größeren Lochungen.

Besonders bevorzugt ist es, wenn die Löcher in eine bereits zumindest weitgehend funktionsfertige Solarzelle eingebracht werden. Mit zumindest weitgehend funktionsfertig ist hierbei gemeint, dass danach gegebenenfalls noch restliche Fertigungsschritte, wie eine Rückkontaktierung oder dergleichen vorgesehen werden können.

Es ist möglich, die Löcher in die auf dem Träger bereits montierte Solarzelle einzubringen, was deshalb besonders vorteilhaft ist, weil dann die Träger und die Solarzellen in einem einzigen Arbeitsgang mit Löchern versehen werden können. Bevorzugt ist jedoch die vorherige Einbringung von Löchern. Im Übrigen ist es möglich, die Solarzellen anstelle des rückwärtigen Trägers zusätzlich und/oder stattdessen mit einem vorderseitigen Träger zu versehen, der entsprechend der gewünschten Opazität gebildet beziehungsweise strukturiert ist. Es wird einleuchtend sein, dass sich der gewünschte optische Effekt unabhängig davon ergibt, ob eine vordere oder rückwärtige Trägerseite mit einer regulären Opazität gebildet wird und auch für sowohl vorderen als auch rückwärtigen Träger eine ordnungsgemäße Solarzellenanordnung erreicht wird. So kann zum Beispiel Glas bedruckt werden, auf dem Glas ein Solarzellenstring über geeignete Prozesse angeordnet und erforderlichenfalls fixiert werden und dann ein weiteres Glas angelegt werden, wobei die Gesamtstruktur laminierbar ist.

Die Erfindung wird im Folgenden nur beispielsweise anhand der Zeichnung beschrieben. In dieser zeigt:
- Fig. 1: eine Draufsicht auf ein Solarzellenmodul von oben;
- Fig. 2: eine Schnittansicht hierdurch.

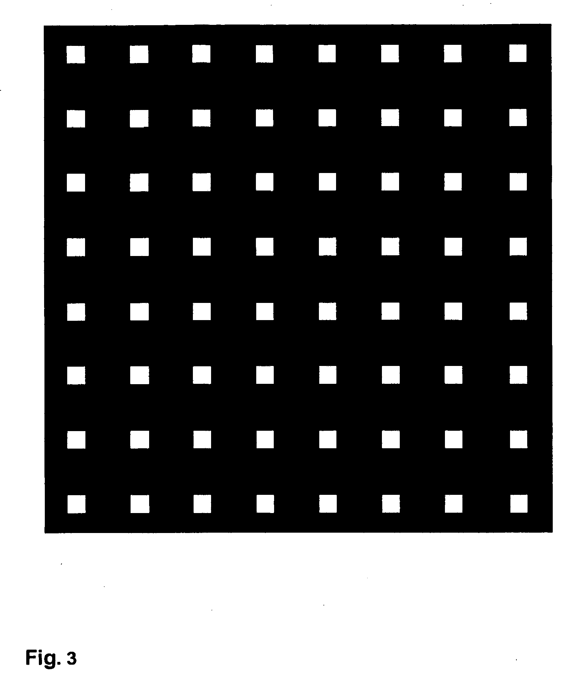

- Fig. 3: eine einzelne Zelle mit viereckigen Löchern.
- Fig. 4: ein Beispiel eines Moduls, bei welchem der Träger voll opak markiert ist.

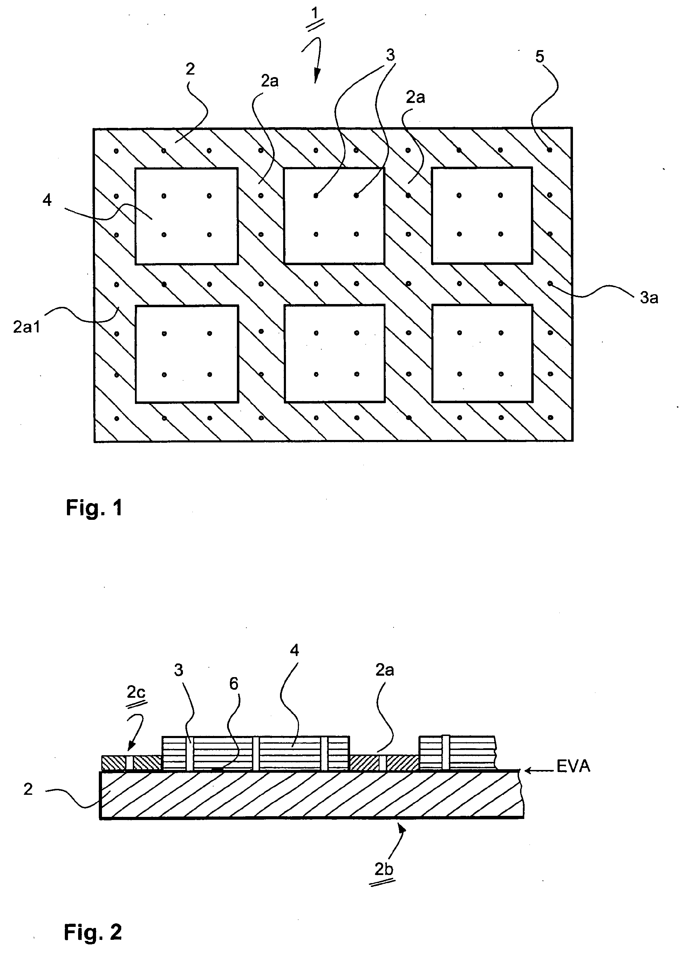

Nach Fig. 1 umfasst ein allgemein mit 1 bezeichnetes Solarmodul 1 einen transparenten Träger 2 und eine Mehrzahl voneinander beabstandeter, durch regulär angeordnete Löcher 3 semitransparenter Solarzellen 4, wobei der Träger an den Solarzellenzwischenräumen 2a eine Ausbildung aufweist, die zusammen mit den regulären Solarzellenlöchern 3 eine reguläre Opazität aufweist.

Das Solarmodul 1 ist im vorliegenden Fall zur Montage in einer Fassade bestimmt und weist eine Größe auf, die sich gut handhaben lässt, beispielsweise 1 x 1 Meter.

Der transparente Träger 2 besteht im vorliegenden Fall wie bevorzugt möglich aus Glas, das solarzellenseitig ganzflächig mit EVA oder einem anderen Material versehen ist und wobei für die Fassadenmontage die wetterzugewandte Seite 2b (vgl. Fig. 2) solarzellenfrei ist, während die Solarzellen auf der Innenseite 2c angeordnet sind. Eine die Solarzellen an ihrer Rückseite ergänzend schützende Deckschicht, wie beispielsweise in bevorzugter Form als Glasscheibe realisiert, ist in einem typischen Ausführungsbeispiel vorgesehen, aber in der Fig. aus Gründen der Übersichtlichkeit nicht dargestellt.

Die Solarzellen 4 sind im vorliegenden Fall kristalline Solarzellen mit Rückseitenkontaktierung, wie bei 6 in Fig. 2 angedeutet. Die Durchführung durch die Solarzellen 4 für die Rückseitenkontaktierung 6 ist im dargestellten Beispiel wie bevorzugt möglich als per se bekannte Durchkontaktierung ausgeführt und von den Löchern verschieden. Diese Durchkontaktierung ist in den Figuren nicht dargestellt.

Die Solarzellen 4 haben im vorliegenden Fall eine Beabstandung 2a voneinander, die eine Anordnung hinreichend vieler Solarzellen auf dem Modul ermöglicht.

Die Solarzellen 4 sind mit Löchern 3 einer Größe zwischen 0,1 und 0,7 cm versehen. Auffallende Beugungseffekte an den Löchern sind für sichtbares Licht somit nicht zu erwarten, die Löcher 3 sind auf der Solarzelle gleichmäßig und regulär angeordnet.

Erfindungsgemäß ist nun der Träger 2 in den Zwischenräumen 2a zwischen den Solarzellen mit einer opaken Bedruckung versehen, wie durch die Schraffur 2a1, Fig. 1, angedeutet. In den opaken Bereichen 2a1 sind wiederum Löcher 3a vorgesehen, die das reguläre Muster der Solarzellen 4 auf dem Träger 2 des Solarzellenmoduls 1 aufnehmen, wobei die Löcher 3a dieselbe Größe besitzen wie die Löcher 3 in den Solarzellen 4 und wobei der Lochabstand, wie bevorzugt möglich, so wählbar ist, dass bei Benutzung im vorgesehenen Abstand zum Solarmodul keine störend auffälligen Einzellöcher mit dem menschlichen Auge beobachtet werden, sondern auch bei größeren Lochdurchmessern durch die Vielzahl und reguläre Anordnung der Eindruck einer gleichmäßigen Durchleuchtung erhalten wird.

Das Solarzellenmodul wird hergestellt wie folgt:

Zunächst wird eine Vielzahl von Solarzellen gefertigt und in per se bekannter Weise mit Kontakten, hier wie möglich, aber nicht zwingend, Rückseitenkontakten versehen. Die Solarzellen werden dann elektrisch miteinander verbunden und in gewünschter Anordnung auf dem Träger 2 aus Glas angeordnet. Danach wird mittels einer geeigneten Schablone eine opake Beschichtung 2a1 auf dem Träger 2 aufgebracht.

Anschließend wird ein reguläres Lochmuster kleiner Löcher mittels eines Lasers in sowohl die opake Beschichtung 2a1 als auch die Solarzellen 4 eingebracht, und zwar jeweils so, dass der Träger 2 selbst nicht beschädigt oder durchlöchert wird. Dies kann eine äquidistante Lochung hervorbringen oder auch vorgegebene Muster.

Nach diesem Schritt wird das Solarzellenmodul zusammen mit den anderen Solarzellenmodulen in einer Fassade montiert.

Die Fassade ist dabei schon bei geringem Lichteinfall so transparent, dass ein hinter der Fassade liegender Raum hinreichend stark diffus beleuchtet wird. Bei starkem Sonneneinfall ist die Beleuchtung im Raum stärker, aber selbst bei unmittelbarem Sonneneinfall, d.h. direkter Sonneneinstrahlung, ergeben sich keine, jedenfalls keine stark störenden Blendeffekte im hinter der Fassade liegenden Raum. Der Beobachter hat durch die Anordnung der Löcher, die so dicht wählbar ist, dass er sie gegebenenfalls bei der vorgesehenen Beabstandung zur Fassade nicht mit dem Auge auflösen kann, zugleich den Eindruck einer homogenen Transparenz.

Es sei erwähnt, dass es möglich ist, einzelne oder alle der Löcher zu hinterleuchten, beispielsweise durch Leuchtdioden, insbesondere weisse oder farbige Leuchtdioden und es sei erwähnt, dass hierfür die Leuchtdioden dichter an die Löcher 3 herangebracht werden können, als dies bei plan ausgestalteter Rückseite des Trägers 2 möglich ist, indem nahe den hinterleuchteten Löchern Ausnehmungen im Träger vorgesehen werden, in welche Dioden oder Diodenteile eingebracht werden. Weiter sei erwähnt, dass es möglich ist, diese Dioden oder andere hinterleuchtende Mittel mit Energiespeichern zu versehen, insbesondere solarzellengespeisten Akkumulatoren.

Im Übrigen sind bei geringerem Lichtbedarf auch weiter auseinander liegende Löcher möglich, selbst wenn diese dann auflösbar sind.

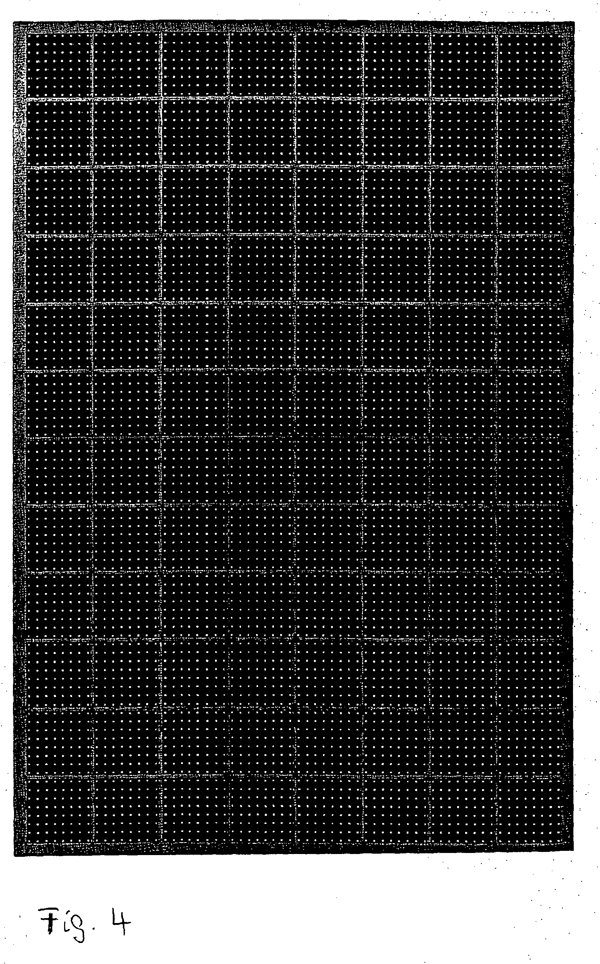

In einem weiteren Herstellungsverfahren können große Löcher in den Solarzellen zum Beispiel mittels Laser vorgesehen werden und die während der Fertigung durchlöcherten Solarzellen dann auf dem Träger angeordnet werden. Die Löcher können mit größeren Abständen zueinander und vom Rand angeordnet werden und es werden dann die Zellen auf einem Träger angeordnet, der an den Solarzellenzwischenräumen mit einer Marke versehen ist, und zwar bevorzugt im Randbereich über die Marke überlappend, vergleiche Fig. 4. In Fig. 4 zeigen die grauen Bereiche den opak markierten Träger, die schwarzen Bereiche die Solarzellen mit weiß gezeichneten Löchern. Auf diese Weise kann eine exakte Anpassung von Trägermarke und Solarzellen durch Überlappungsveränderung zu einer hohen Gesamtregularität bei geringen Kosten führen.

Während vorstehend beschrieben wurde, dass die Zellen zunächst elektrisch miteinander verbunden werden und der so erzeugte String aus verbundenen Zellen auf dem Träger angeordnet wird, ist dies nicht zwingend und es ist vielmehr auch möglich, zunächst die Zellen auf dem Träger anzuordnen und hernach miteinander elektrisch zu verbinden.

Anders als vorstehend beschrieben, ist es möglich, Löcher und dergleichen bereits vor Montage der Solarzellen auf einen Träger in die Solarzellen einzubringen, beispielsweise durch Laser, Wasserstrahl und/oder zum Beispiel nach dem Verfahren gemäß EP 0 747 959. Auch kann ein Lochmuster auf einer Trägerbeschichtung vorgesehen werden, indem zum Beispiel die Beschichtung mit Lochmuster aufgedruckt wird, wie dies mit gängigen Verfahren möglich ist, zum Beispiel Siebdruck, offsetdruck o. ä. Auch könnte auf den Träger eine entsprechend strukturierte Folie auflaminiert werden.

## Patentansprüche

1. Solarmodul mit einem transparenten Träger und einer Mehrzahl voneinander beabstandeter, durch regulär angeordnete Löcher semitransparenter Solarzellen, **dadurch gekennzeichnet, dass** der Träger an den Solarzellenzwischenräumen eine Ausbildung aufweist, die zusammen mit den regulären Solarzellenlöchern eine reguläre Opazität ergibt.

2. Solarmodul nach dem vorhergehenden Anspruch, **dadurch gekennzeichnet, dass** der Träger an den Solarzellenzwischenräumen eine allgemein opake Ausbildung aufweist, insbesondere mit entsprechend den regulären Solarzellenlöchern angeordneten geringer opaken Bereichen.

3. Solarmodul nach einem der vorhergehenden Ansprüche, **dadurch gekennzeichnet, dass** der Träger im sichtbaren und/oder infraroten Spektralbereich transparent ist.

4. Solarmodul nach einem der vorhergehenden Ansprüche, **dadurch gekennzeichnet, dass** der Träger aus Glas oder Kunststoff, insbesondere PMMA besteht.

5. Solarmodul nach einem der vorhergehenden Ansprüche, **dadurch gekennzeichnet, dass** die Solarzellen gleichmäßig nebeneinander angeordnet sind.

6. Solarmodul nach einem der vorhergehenden Ansprüche, **dadurch gekennzeichnet, dass** die Löcher äquidistant und/oder formfolgend auf dem Träger und/oder den Solarzellen angeordnet sind.

7. Solarmodul nach einem der vorhergehenden Ansprüche, **dadurch gekennzeichnet, dass** zumindest nahe der Löcher eine Hinterleuchtung vorgesehen ist.

8. Solarmodul nach dem vorhergehenden Anspruch, **dadurch gekennzeichnet, dass** ein Speichermittel für von der Hinterleuchtung benötigte Energie mit zumindest einigen der Solarzellen zur Energieeinspeicherung in das Speichermittel gekoppelt ist.

9. Solarmodul nach einem der vorhergehenden Ansprüche, **dadurch gekennzeichnet, dass** die Solarzellen kristalline Solarzellen umfassen.

10. Solarmodul nach einem der vorhergehenden Ansprüche, **dadurch gekennzeichnet, dass** die opake Ausbildung durch eine zumindest partielle Beschichtung und/oder Bedruckung auf dem Träger gebildet ist.

11. Solarmodul nach einem der vorhergehenden Ansprüche, **dadurch gekennzeichnet, dass** die geringer opaken Bereiche volltransparent sind und/oder stark lichtstreuend.

12. Solarmodul nach einem der vorhergehenden Ansprüche, **dadurch gekennzeichnet, dass** die Solarzellen als Rückkontaktsolarzellen ausgebildet sind.

13. Solarmodul nach einem der vorhergehenden Ansprüche, **dadurch gekennzeichnet, dass** die Löcher in einem typischen oder vorgesehenen Benutzerabstand einen nicht mehr voneinander auflösbaren Abstand besitzen.

14. Solarmodul nach einem der vorhergehenden Ansprüche, worin die Solarzellenabstände auf dem Träger geringer als der Lochabstand sind und insbesondere die Solarzellenmodule in einem Randbereichstreifen lochfrei sind, um bei Anordnung auf einer Trägermaske, insbesondere am lochfreien Randstreifen unter Überlappung mit dem Trägermaskenrandbereich ausschließlich durch Solarzellenlöcher eine Transparenz zu bewirken.

15. Verfahren zur Herstellung eines Solarmoduls aus einem Träger und einer Vielzahl von regulär angeordneten Löchern aufweisenden kristallinen Solarzellen, insbesondere nach einem der vorhergehenden Ansprüche, **dadurch gekennzeichnet, dass** die Löcher durch Bohren, Laserschneiden, Ultraschallschneiden und/oder Stanzen in die Solarzellen eingebracht werden.

16. Verfahren nach dem vorhergehenden Verfahrensanspruch, **dadurch gekennzeichnet, dass** die Löcher in eine zumindest funktionsfähig fertig prozessierte Solarzelle eingebracht werden.

17. Verfahren nach einem der vorhergehenden Verfahrensansprüche, **dadurch gekennzeichnet, dass** die Löcher in die Solarzellen vor Trägermontage eingebracht werden.
